# EUROPÄISCHE PATENTSCHRIFT

(11) **EP 0 715 771 B1**
(45) Veröffentlichungstag und Bekanntmachung des Hinweises auf die Patenterteilung: **01.09.1999**
(21) Anmeldenummer: 95925771.8
(22) Anmeldetag: 27.06.1995
(51) Int. Cl.: H01L 29/808, H01L 29/24, H01L 21/34

(54) **FELDEFFEKT-TRANSISTOREN AUS SiC UND VERFAHREN ZU IHRER HERSTELLUNG**
SiC FIELD-EFFECT TRANSISTORS AND METHOD OF MANUFACTURING THEM
TRANSISTOR SiC A EFFET DE CHAMP ET SON PROCEDE DE FABRICATION

(30) Priorität: 01.07.1994 DE 4423068
(43) Veröffentlichungstag der Anmeldung: 12.06.1996
(73) Patentinhaber: DaimlerChrysler AG, 70567 Stuttgart (DE)
(72) Erfinder: LOOSE, Werner, D-73765 Neuhausen (DE); KORE , Jacek, D-64546 Mörfelden-Walldorf (DE); NIEMANN, Ekkehard, D-63477 Maintal (DE); BOOS, Alfred, D-55118 Mainz (DE)
(74) Vertreter: Fröhling, Werner Otto, Dr.
(86) Internationale Anmeldenummer: EP9502496
(87) Internationale Veröffentlichungsnummer: WO9601500

(56) Entgegenhaltungen:
- DE-A- 4 310 345
- US-A- 4 262 296
- US-A- 4 941 026
- US-A- 4 947 218
- US-A- 5 323 040
- PATENT ABSTRACTS OF JAPAN vol. 13 no. 493 (E-842) ,8.November 1989 & JP,A,01 196873 (SHARP CORP) 8.August 1989,
- IEEE TRANSACTIONS ON ELECTRON DEVICES, Bd. ED-25, Nr. 1, Januar 1978 NEW YORK US, Seiten 56-57, OSAMU OZAWA ET AL 'A Vertical FET with Self-Aligned Ion-Implantated Source and Gate Regions'
- ESSDERC '91: 21ST EUROPEAN SOLID STATE DEVICE RESEARCH CONFERENCE, MONTREUX, SWITZERLAND, 16-19 SEPT. 1991, MICROELECTRONIC ENGINEERING, OCT. 1991, NETHERLANDS, GRUHLE A ET AL 'Silicon etched-groove permeable base transistor fabrication with cutoff frequencies (f/sub T/, f/sub max/) above 25 GHz'
- Physics of Semiconductor Devices, S.M. Sze; John Wiley & Sons, ed.; 1981, Seiten 312, 313

## Beschreibung

Die Erfindung betrifft ein Verfahren zur Herstellung von Feldeffekt-Transistoren aus SiC.

Für hohe Spannung hat sich SiC wegen seiner großen Bandlücke angeboten und es sind verschiedene Vorschläge zur Realisierung von Feldeffekt-Transistoren für hohe Spannungen gemacht worden.

In dem Buch von S.M. Sze, Physics of Semiconductor Devices, John Wiley & Sons, 1981, Seiten 312-313 sind drei Silizium-Feldeffekt-Transistortypen, MOSFET, MESFET und JFET, abgehandelt. In der JP-A-1 196 873 ist ein MOSFET und ein MESFET aus SiC offenbart. In der US-A-5 323 040 ist ein SiC-MOSFET vorgeschlagen, der in Trenchtechnologie hergestellt wird. In der US-A-4 941 026 ist ein Si-MOSFET mit einem minimalen On-Widerstand offenbart.

In der Siliziumtechnologie ist es aus dem Buch von B. Jayant Baliga: "Modern Power Devices", N.Y. 1987, bekannt, die dort beschriebene "Surface-Gate Technology" zu benutzen. Um die Gate-Regionen von Leistungs-JFETs herzustellen, ist es nicht besonders günstig, die Planartechnik zu verwenden. Unabhängig davon, ob man die Silizlum- oder die SiC-Technik verwendet, führt eine nicht deckungsgenaue Anordnung der Masken zu Kurzschlüssen, wenn die üblichen Dimensionen der Bauelemente verwendet werden. Um dennoch die für eine gute Sperrfähigkeit notwendigen kleinen Abmessungen der Bauelemente zu erhalten, wird in dem o. a. Buch vorgeschlagen, das Gate zu versenken. Wie leicht einzusehen ist, hat diese Anordnung des Gate-Kontakts in einem vertikalen Graben, in dessen Wände Bor eindiffundiert, technologische Vorteile. Insbesondere wird das Anbringen des Gate-Kontakts durch Metallisieren dadurch erleichtert, daß sich das Metall an den Wänden kaum niederschlägt und dadurch ein separater Maskierungsschritt eingespart wird.

Es ist nun natürlich wünschenswert, diese Technik auch auf das Material SiC zu übertragen. Dem stehen aber verschiedene Schwierigkeiten entgegen.
1. Die Eindiffusion des Dotierstoffes ist nicht möglich, da bei den üblichen Prozeßtemperaturen in SiC praktisch keine Diffusion stattfindet.
2. Da in SiC eine höhere kritische Feldstärke möglich ist, kann man die Strukturen um den Faktor 5 - 10 verkleinern. Eine entsprechende laterale Skalierung führt an die Grenze der Maskentechnik. Wenn die geometrische Kanalbreite nicht entsprechend verkleinert werden kann, verschlechtert sich das Abschnürverhalten.

Der Erfindung liegt die Aufgabe zugrunde, ein Verfahren zur Herstellung einer Struktur bei Feldeffekt-Transistoren der eingangs genannten Art anzugeben, bei welcher ein ausreichendes Abschnürverhalten in der Kanalzone durch eine möglichst kleine Gatespannung erreicht werden kann.

Diese Aufgabe wird durch die im Kennzeichen des Anspruchs 1 aufgeführten Merkmale gelöst. Weiterbildungen der Erfindung sind in den Unteransprüchen dargestellt.

Die Erfindung besteht darin, daß auf einem niederohmigem Substrat eine epitaxiale SiC-Schicht abgeschieden und eine n⁺-Zone hergestellt wird, wobei durch Gräben getrennte inselförmige Bereiche rotationssymmetrisch ausgebildet und Grabenwände und Grabenböden durch p⁺-Ionenimplantation dotiert werden, anschließend die Gräben durch einen Isolator aufgefüllt und durch Polieren und/oder Ätzen die Kontaktierung von Sources vorbereitet und schließlich der Source-Kontakt aufgebracht wird.

Erfindungsgemäß sind die so hergestellten Bauelemente nicht mehr streifenförmig, sondern rotationssymmetrisch aufgebaut. Dadurch kann die Abschnürung des Kanals von allen Seiten des ringförmigen Gate-Kontakts auf dem Grabenboden und von den Seitenwänden aus erfolgen. Weil Eindiffusion nicht möglich ist, wird die Dotierung vorzugsweise mittels Ionenimplantation durchgeführt. Dies wird besonders leicht, wenn das mesaförmige Bauelement schräge Seitenwände aufweist. Aufgrund der schrägen Seitenwände ist die Dotierung mit Bor oder anderen dreiwertigen Dotierstoffen durch Ionenimplantation leicht möglich. Die mesaförmigen Bauelemente werden zum Erzielen großer Leistungen parallel geschaltet. Die Gate-Kontakte werden in den Gräben geführt, die Source-Kontaktierung erfolgt auf der Oberseite der Siliziumscheibe und der Drain-Anschluß ist auf der Unterseite angebracht.

Die Erfindung wird nachstehend anhand der Zeichnung näher erläutert.

Dabei zeigt:
- Fig. 1: eine Ausführungsform der Bauelemente in Draufsicht;
- Fig. 2: das Herstellungsverfahren nach der vorliegenden Erfindung in verschiedenen Phasen;
- Fig. 3: eine vereinfachte Struktur des Einzelbauelementes für Simulationsrechnungen und
- Fig. 4: Ergebnisse von Simulationsrechnungen für zwei verschiedene Geometrien.

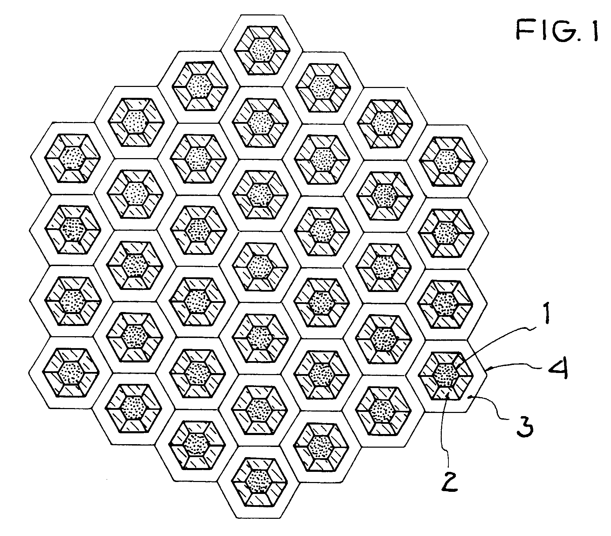

Bei einer Ausführungsform eines JFET, wie sie beispielsweise in der Fig. 1 in einem Zwischenstadium schematisch dargestellt ist, sind die Bauelemente sechseckig und haben beispielsweise einen Durchmesser von etwa 6 µm. Der Source-Kontakt 1 ist erhaben, die Seitenwände 2 des ringförmigen Grabens sind schräg. Die Gate-Kontakte 4 auf dem Boden des Grabens 3 umgeben die einzelnen Bauelemente und verbinden sie gleichzeitig.

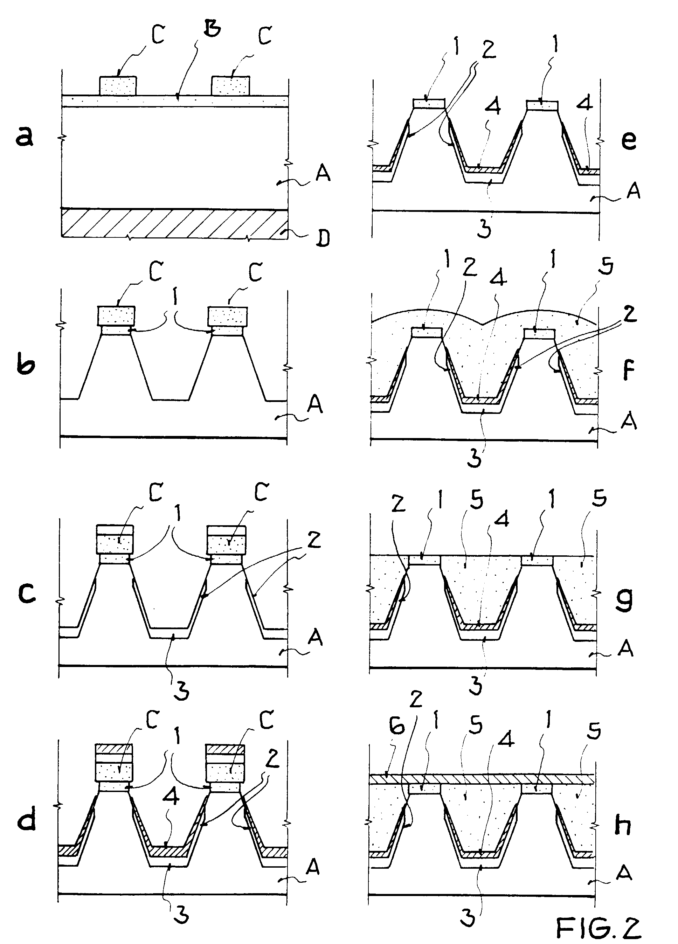

Die Herstellung des JFET mittels eines selbstjustierenden Einmasken-Prozesses nach der vorliegenden Erfindung wird anhand der Fig. 2 näher erläutert. Dieses Verfahren stellt ein bevorzugtes Beispiel dar; die grundlegenden Prozesse können aber auch in anderer Weise leicht abgewandelt durchgeführt werden, beispielsweise indem als Substrat D eine SiC- oder Siliziumscheibe verwendet wird.

Der Herstellungsprozeß zerfällt in acht einzelne Schritte a bis h. Eine Epi-Schicht A aus SiC, mit einer Dicke von ca. 20 µm wird mit einer Dotierung von 10¹⁶ cm⁻³ auf dem Substrat D abgeschieden. Dieses Substrat besteht vorzugsweise aus einer 200 - 300 µm dicken SiC-Scheibe und ist mit einem Donator von 10¹⁸ cm⁻³ dotiert. Die daran angrenzende Unterseite der SiC-Schicht wird metallisiert und bildet die Drain-Elektrode (nicht dargestellt).

Die Schicht B ist eine n⁺-dotierte Zone, die in-situ aufgewachsen ist oder ionenimplantiert ist (N = 10¹⁸ cm ⁻³).

Fig. 2a zeigt eine Oxidmaske C, welche anschließend aufgebracht wird und welche an diesem Beispiel eine Stegbreite von ca. 2 µm aufweist, 1 µm dick ist und beispielsweise aus SiO₂ besteht. In Teil b der Fig. 2 wird der nächste Schritt dargestellt. Zunächst wird das SiO₂ strukturiert, welches naßchemisch mit leichter Unterätzung der Oxidmaske C erfolgt. Im nächsten Schritt wird ein sog. RIE-Prozeß der schrägen Gräben mittels einer Gasmischung durchgeführt. Die Gasmischung besteht aus Cl₂/SiCl₄/O₂/Ar oder N₂ anstelle von Ar. Die Konzentrationen sind in der Reihenfolge der Aufzählung: 40/20/4,2/10 sccm. Die Tiefe des Grabens beträgt ca. 4 bis 5 µm. Sie ist damit etwa doppelt so groß wie der Durchmesser.

Teil c der Fig. 2 zeigt die p⁺-Ionenimplantation. Diese wird beispielsweise mit Al, B oder einem anderen dreiwertigen Element durchgeführt. Die Tiefe beträgt ca. 0,5 µm und wird durch Mehrfachimplantation mit Energien E < 500 keV erreicht. Die Implantation kann von oben, d. h. senkrecht zu der Oberfläche der Siliziumscheibe oder schräg und unter fortwährender Rotation erfolgen. Dabei entsteht im Bereich der Grabenwand der dotierte Bereich 2 und im Bereich des Bodens der Bereich 3.

Im Teil d der Fig. 2 wird die Metallisierung der Gate-Kontakte 4 gezeigt. Sie werden durch Aufsputtern von z. B. Ti, Ni, NiCr oder anderen Metallisierungssystemen hergestellt. Die Herstellung von Schottky-Kontakten geschieht einfach dadurch, daß der Bereich 2 nicht dotiert wird.

In Fig. 2e ist das Ergebnis des sog. Lift-off-Prozesses dargestellt. Dabei wird auch die dünne Metallschicht an den Grabenwänden weggeätzt, evtl. auch mit einem zusätzlichen Ätzprozeß.

Das Auffüllen der Gräben mit einem Isolator 5 wird in der nächsten Fig. 2f dargestellt. Für dieses Auffüllen verwendet man üblicherweise ein CVD-SiO₂.

In der Fig. 2g ist die Scheibe nach dem mechanischen Polieren der Oberfläche des Oxids 5 dargestellt, wobei ein natürlicher Polierstop durch die große Härte des SiC gegeben ist. Um die metallische Kontaktierung des nächsten Schrittes vorzubereiten, ist evtl. ein Ätzvorgang als Zwischenschritt einzufügen. Wenn die Oxidschicht einigermaßen eben ist und über die für den Kontakt dotierte Schicht 1 nicht wesentlich hinausragt, ist auch ein Verfahren ohne Politur, allein durch Ätzung möglich. Diese Schicht 1 besteht aus Inseln, welche durch Strukturierung aus der Schicht B entstehen.

Als letzten Schritt wird man eine ganzflächige metallische Beschichtung vornehmen, um den Source-Kontakt 6 herzustellen.

Eine großflächige Parallelschaltung der Elementarbauelemente läßt sich beispielsweise in einer hexagonalen Struktur erreichen, wie sie in Fig. 1 dargestellt ist. Die Gate-Kontakte 4 in den Gräben sind hier als dünne Linien angedeutet und werden dabei nach außen und dort auf Kontaktbahnen geführt. Die Source-Kontaktierung erfolgt ganzflächig auf der Oberseite der Halbleiterscheiben, während der dritte Anschluß (Drain-Anschluß) auf der Unterseite der Halblelterscheibe vorgesehen ist.

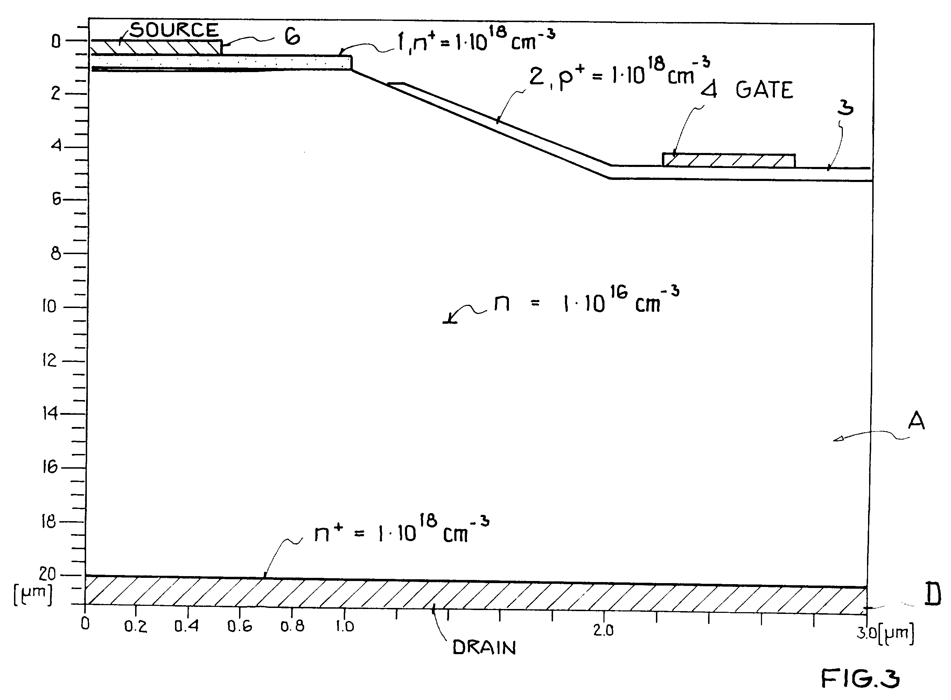

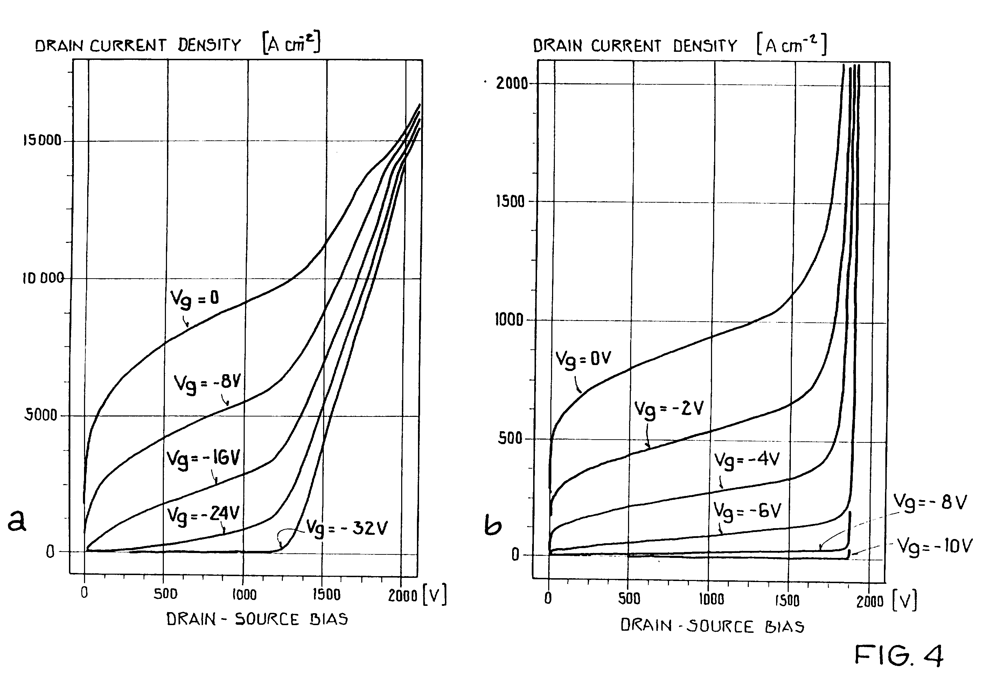

Zur Optimierung der verschiedenen Parameter wurde eine Computersimulation für eine maximale Sperrspannung von 2 kV durchgeführt. Die elektrischen Kennlinien des in Fig. 3 dargestellten Elementarbauelements wurden mit Hilfe einer Computersimulation ermittelt. Die bei einer rotationssymmetrischen Auslegung erheblich verbesserten Abschnüreigenschaften sind in Fig. 4 belegt. Eine Sperrspannung von 1900 V kann bei einer Gatespannung von -10 V in der rotationssymmetrischen Struktur erhalten werden. Wie im linken Teil der Fig. 4 für streifenförmige Geometrie dargestellt ist, gelingt dies selbst bei einer Gatespannung von - 32 V nicht.

Für Drainspannungen U_{D} < 3 V liest man aus den Simulationen einen On-Widerstand von Rₒₙ = 0,013 Ωcm² ab, der damit um einen Faktor von ca. 100 kleiner ist als bei einem Si-Bauelement gleicher Sperrfähigkeit. Legt man eine maximale Leistungsdichte von 100 - 200 W/cm² zugrunde, so ergeben sich daraus maximale Stromdichten im Bereich von 130 bis 180 A/cm².

## Patentansprüche

1. Verfahren zum Herstellen von Feldeffekt-Transistoren aus SiC mit Source-, Drain- und Gate-Kontakten, wobei eine epitaxiale Schicht (A) aus SiC auf einem Substrat (D), an dessen Unterseite eine Drain-Elektrode angeordnet wird, abgeschieden wird, und Gate-Bereiche in Gräben (3) angeordnet und Gate-Kontakte (4) durch Metallisierung hergestellt werden, wobei auf dieser Schicht (A) mit Hilfe einer Maskentechnik von Gräben (3) umgebene inselförmige Bereiche (1) herausgeätzt werden und anschließend die Maske (C) entfernt wird,
wobei weiterhin,
das Substrat (D) niederohmig ist, auf der Oberfläche der Schicht (A) eine n⁺-Zone (B) hergestellt wird, die inselförmigen Bereiche rotationssymmetrisch ausgebildet werden, die Grabenwände (2) und die Grabenböden (3) durch p⁺-Ionenimplantation dotiert werden, die Gräben durch einen Isolator (5) aufgefüllt werden, durch Polieren und/oder Ätzen die Kontaktierung der Sources vorbereitet wird und schließlich der Source-Kontakt (6) aufgebracht wird.

2. Verfahren nach Anspruch 1,
dadurch gekennzeichnet,
daß eine Maske (C) aufgebracht wird, welche durch eine Strukturbreite von 0,5 bis 3 µm charakterisiert wird.

3. Verfahren nach Anspruch 1 oder 2,
dadurch gekennzeichnet,
daß die Maske (C) aus einem Isolator besteht, welcher aus Si, O und/oder N hergestellt wird.

4. Verfahren nach einem der Ansprüche 1 bis 3,
dadurch gekennzeichnet,
daß die Maske (C) naßchemisch geätzt und leicht unterätzt wird.

5. Verfahren nach einem der Ansprüche 1 bis 4,
dadurch gekennzeichnet,
daß die Gräben (3) mittels einer Gasmischung aus Cl₂/SiCl₄/O₂/Ar oder N₂ anstelle von Argon mittels eines sogenannten RIE-Prozesses hergestellt werden, wobei Konzentrationen der Gase 40/20/4,2/10 sccm in der Reihenfolge der Aufzählung betragen.

6. Verfahren nach einem der Ansprüche 1 bis 5,
dadurch gekennzeichnet,
daß der Ätzprozeß solange durchgeführt wird, bis die Tiefe des Grabens (3) 2-10 µm und die Breite 3-10 µm beträgt.

7. Verfahren nach einem der Ansprüche 1 bis 6,
dadurch gekennzeichnet,
daß eine Implantation mit einem dreiwertigen Element mit Energien E < 2 MeV durchgeführt wird, wobei die Ionen von oben auf die Siliziumkarbidoberfläche auftreffen.

8. Verfahren nach einem der Ansprüche 1 bis 7,
dadurch gekennzeichnet,
daß bei schrägem Einfall der Ionen die Halbleiterscheibe rotiert, so daß im Bereich der Grabenwände (2) gleichmäßig dotierte Bereiche (2) entstehen.

9. Verfahren nach einem der Ansprüche 1 bis 8,
dadurch gekennzeichnet,
daß mit einem zusätzlichen Ätzprozeß die durch Metallisierung der Gate-Kontakte (4) entstehende dünne Metallschicht an den Grabenwänden (2) weggeätzt wird.

10. Verfahren nach einem der Ansprüche 1 bis 9,
dadurch gekennzeichnet,
daß die Gräben (3) durch CVD-SiO₂ aufgefüllt werden.

11. Verfahren nach einem der Ansprüche 1 bis 10,
dadurch gekennzeichnet,
daß die Maske (C) so strukturiert wird, daß eine hexagonale Struktur der Source-Kontakte (6) und Gräben (3) entsteht.

## Claims

1. Method of manufacturing field effect transistors of SiC with source, drain and gate contacts, wherein an epitaxial layer (A) of SiC is deposited on a substrate (D), at the underside of which a drain electrode is arranged, and gate regions are arranged in trenches (3) and gate contacts (4) are produced by metallisation, wherein island-shaped regions (1) surrounded by trenches (3) are etched out on this layer (A) with the aid of a masking technique and subsequently the mask (C) is removed, wherein moreover the substrate (D) has low resistance, an n⁺ zone (B) is produced on the surface of the layer (A), the island-shaped regions are formed to be rotationally symmetrical, the trench walls (2) and the trench bases (3) are doped by p⁺ ion implantation, the trenches are filled up by an insulator (5), the contacting of the source is prepared by polishing and/or etching and finally the source contact (6) is applied.

2. Method according to claim 1, characterised in that a mask (C) is applied, which is characterised by a structure width of 0.5 to 3 micrometres.

3. Method according to claim 1 or 2, characterised in that the mask (C) consists of an insulator, which is produced from Si, O and/or N.

4. Method according to one of claims 1 to 3, characterised in that the mask (C) is chemically wet-etched and lightly under-etched.

5. Method according to one of claims 1 to 4, characterised in that the trenches (3) are produced by means of a so-called RIE process by means of a gas mixture of Cl₂/SiCl₄/O₂/Ar or N² instead of argon, wherein concentrations of the gases amount to 40/20/4.2/10 sccm in the sequence of the listing.

6. Method according to one of claims 1 to 5, characterised in that the etching process is carried until the depth of the trench (3) amounts to 2 to 10 micrometres and the width to 3 to 10 micrometres.

7. Method according to one of claims 1 to 6, characterised in that an implantation is carried out with a trivalent element with energies E < 2 MeV, wherein the ions impinge from above onto the silicon carbide surface.

8. Method according to one of claims 1 to 7, characterised in that in the case of oblique incidence of the ions, the semiconductor wafer rotates so that uniformly doped regions (2) arise in the region of the trench walls (2).

9. Method according to one of claims 1 to 8, characterised in that the thin metal layer, which arises through metallisation of the gate contacts (4), at the trench walls (2) is etched away by an additional etching process.

10. Method according to one of claims 1 to 9, characterised in that the trenches (3) are filled up by CVD SiO₂.

11. Method according to one of claims 1 to 10, characterised in that the mask (C) is so structured that a hexagonal structure of the source contacts (6) and trenches (3) arises.

## Revendications

1. Procédé de fabrication de transistors SiC à effet de champ avec des contacts de source, de drain et de porte, où une couche épitaxiale (A) en SiC est séparée sur un support (D), au côté inférieur duquel est disposée une électrode de drain, et où des zones de porte sont disposées dans des fossés (3) et des contacts de porte (4) sont réalisés par métallisation, où sont gravés sur cette couche (A), à l'aide d'une technique de masquage, des zones en forme d'îlot entourées par des fossés (3) et ensuite, le masque (C) est retiré,
où en outre
le support (D) est à faible résistance, est réalisée sur la surface de la couche (A) une zone n⁺ (B), les zones en forme d'îlot sont réalisées d'une manière symétrique en rotation, les parois de fossé (2) et les fonds de fossé (3) sont dotés par des implantations d'ions p⁺, les fossés sont remplis par un isolateur (5), par polissage et/ou gravure, l'établissement de contact des sources est préparé et enfin, le contact de source (6) est appliqué.

2. Procédé selon la revendication 1,
caractérisé en ce
qu'un masque (C) est appliqué, qui est caractérisé par une largeur de structure de 0,5 à 3 µm.

3. Procédé selon la revendication 1 ou 2,
caractérisé en ce que
le masque (C) est constitué d'un isolateur qui est fabriqué en Si, O et/ou N.

4. Procédé selon l'une des revendications 1 à 3
caractérisé en ce que
le masque (C) est gravé chimiquement par voie humide et est légèrement gravé de manière sous-jacente.

5. Procédé selon l'une des revendications 1 à 4
caractérisé en ce que
les fossés (3) sont réalisés au moyen d'un mélange de gaz de Cl₂/SiCl₄O₂/Ar ou N₂ à la place de l'argon au moyen d'un soi-disant procédé RIE, où les concentrations des gaz sont de 40/20/4,2/10 sccm dans l'ordre de l'énumération.

6. Procédé selon l'une des revendications 1 à 5
caractérisé en ce que
le procédé de gravure est exécuté jusqu'à ce que la profondeur du fossé (3) est de 2-10µm et la largeur de 3-10µm.

7. Procédé selon l'une des revendications 1 à 6,
caractérisé en ce
qu'un implant est réalisé avec un élément trivalent avec des énergies E < 2 MeV, où les ions heurtent depuis au-dessus la surface de carbure de silicium.

8. Procédé selon l'une des revendications 1 à 7,
caractérisé en ce que
lors d'une incidence en biais des ions, la rondelle semi-conductrice tourne de manière à produire au voisinage des parois du fossé (2) des zones régulièrement dotées (2).

9. Procédé selon l'une des revendications 1 à 8
caractérisé en ce que
par un procédé de gravure additionnel, la couche métallique mince produite par la métallisation des contacts de porte (4) est éliminée par gravure aux parois des fossés (2).

10. Procédé selon l'une des revendications 1 à 9
caractérisé en ce que
les fossés (3) sont remplis par du CVD-SiO₂.

11. Procédé selon l'une des revendications 1 à 10
caractérisé en ce que
le masque (C) est structuré de façon à produire une structure hexagonale des contacts de source (6) et des fossés (3).
